# EUROPEAN PATENT SPECIFICATION

(11) **EP 2 472 613 B1**
(45) Date of publication and mention of the grant of the patent: **28.11.2018**
(21) Application number: 10811983.5
(22) Date of filing: 27.08.2010
(51) Int. Cl.: H01L 33/54, H01L 33/50

(54) **LIGHT-EMITTING DEVICE**
LICHTEMITTIERENDE VORRICHTUNG
DISPOSITIF ÉLECTROLUMINESCENT

(30) Priority: 27.08.2009 JP 2009197139
(43) Date of publication of application: 04.07.2012
(73) Proprietor: Kyocera Corporation, Kyoto-shi Kyoto 612-8501 (JP)
(72) Inventor: ITOU, Hiroki, Higashiomi-shi Shiga 529-1595 (JP); SAKUMOTO, Daisuke, Higashiomi-shi Shiga 529-1595 (JP)
(74) Representative: Viering, Jentschura & Partner mbB Patent- und Rechtsanwälte
(86) International application number: PCT/JP2010/064553
(87) International publication number: WO 2011/024934

(56) References cited:
- WO-A2-2007/007236
- JP-A- 2007 116 138
- JP-A- 2007 180 066
- JP-A- 2007 200 949
- JP-A- 2007 234 637
- JP-A- 2009 043 836
- US-A1- 2002 063 520
- US-A1- 2008 029 778

## Description

### Technical field

The present invention relates to a light-emitting device including a light-emitting element, as described in the preamble of claim 1.

### Background Art

A light-emitting device of the aforementioned type is described in JP 2007116138 A, for example.

In recent years, developments directed toward producing light-emitting devices which are of the type having a light source including a light-emitting element have been under way. Such a light-emitting device with a light-emitting element is noteworthy for its feature as to power consumption or product lifetime. For example, in the field of residential luminaire technology, the light-emitting device with a light-emitting element is required to possess the capability of emitting light portions of a plurality of color temperatures in a selective manner.

By way of example, there is a light-emitting device designed to convert light emitted from a light-emitting element into light lying in a specific band of wavelengths by means of a wavelength converter, and produce output of the light (refer to Japanese Unexamined Patent Publication JP-A 2004-343149, for example).

There has been an increasing demand for further improvement in the light-emitting device in terms of light output uniformity. That is, the light-emitting device needs to be so contrived that, when viewed in a plan view, its midportion and periphery are made uniform in light output capability.

JP 2007200949 A, JP 2009043836 A, JP 2007234637 A, US 2008029778 A1, and US 2002063520 A1 describe light-emitting devices.

### Summary of Invention

The present invention provides a light-emitting device according to claim 1. Further advantageous embodiments of the light-emitting device of the present invention are disclosed in the dependent claims.

### Brief Description of Drawings

Fig. 1 is a sectioned perspective view showing a schematic overview of a light-emitting device according to an example not forming part of the present invention;
Fig. 2 is a sectional view of a light-emitting device according to Fig. 1;
Fig. 3 is a sectional view showing a condition of travel of light from the light-emitting device as shown in Fig. 2;
Fig. 4 is a sectional view of another example of a light-emitting device not forming part of the present invention; and
Fig. 5 is a sectional view of an embodiment of a light-emitting device according to the present invention.

### Detailed Description

Hereinafter, an embodiment of a light-emitting device pursuant to the invention will be described with reference to the accompanying drawings. It should be noted that the invention is not limited to the embodiment as set forth hereinbelow.

### <General structure of light-emitting device>

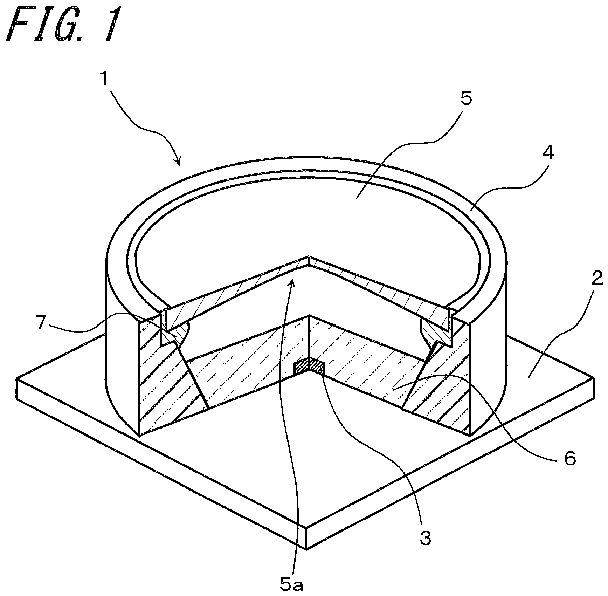

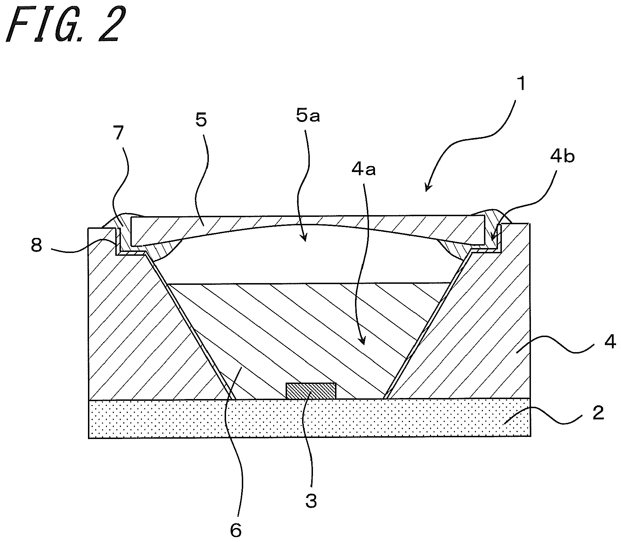

Fig. 1 is a schematic perspective view, partly in section, of a light-emitting device 1 according to an example not forming part of the present invention. Moreover, Fig. 2 is a sectional view of the light-emitting device shown in Fig. 1.

The light-emitting device 1 according to this example includes: a substrate 2; a light-emitting element 3 mounted on the substrate 2; a frame 4 disposed on the substrate 2 so as to surround the light-emitting element 3; and a wavelength converter 5 supported on the frame 4 so as to be opposed at an interval from the light-emitting element 3. For example, the light-emitting element 3 is a light emitting diode for emitting light to the outside by exploiting electron-positive hole reunion in semiconductor-based p-n junction.

The substrate 2 is an insulating substrate made of a ceramic material such as alumina or mullite, a glass ceramic material or the like, or a composite material obtained by mixing two or more of those materials. Also, polymeric resin containing metal oxide fine particles in a dispersed state may be used for the substrate 2.

The substrate 2 is formed with a wiring conductor for permitting electrical conduction between the interior of the substrate 2 and the exterior thereof. The wiring conductor is made of an electrically conductive material such as tungsten, molybdenum, manganese, copper, or the like. For example, the wiring conductor can be obtained by a method including a step of preparing a metal paste by adding an organic solvent to powder of tungsten or the like, a step of printing the metal paste in a predetermined pattern onto ceramic green sheets constituting the substrate 2, a step of laminating a plurality of the ceramic green sheets on top of each other, and a step of firing the resultant. Note that the surface of the wiring conductor exposed internally or externally of the substrate 2 is clad with a plating layer made of nickel, gold, or the like for protection against oxidation.

Moreover, in the interest of efficient reflection of light above the substrate 2, an upper face of the substrate 2 is formed with a metallic reflection layer made of aluminum, silver, gold, copper, platinum, or the like at an interval from the wiring conductor and the plating layer. Instead of the metallic reflection layer, an insulating transparent member such as white ceramic powder-containing silicone resin can be applied to the upper face of the substrate 2, excluding an area bearing the light-emitting element. In this way, light emitted from the light-emitting element 3 is reflected diffusively from the top of the substrate 2, and is allowed to enter the wavelength converter 5 without converging to a part of the wavelength converter 5. As a result, the light emitted from the light-emitting element 3 is less likely to converge to a specific location of the wavelength converter 5, wherefore a decline in conversion efficiency in the specific location of the wavelength converter 5, or a decline in transmittance caused by a temperature rise in the specific location of the wavelength converter 5, can be suppressed effectively.

The light-emitting element 3 is mounted on the substrate 2. More specifically, the light-emitting element 3 is placed, for electrical connection, on the plating layer adhered to the surface of the wiring conductor formed on the substrate 2 via, for example, a brazing material or solder.

For example, an element for giving off excitation light of a wavelength region in a range of 370 nm or more and 420 nm or less can be used for the light-emitting element 3. Note that there is no particular limitation to the light-emitting element 3 so long as it is capable of giving off light ranging from 370 nm to 420 nm in terms of center wavelength.

In this construction, the light-emitting element substrate of the light-emitting element 3 has, on its surface, a light emitting layer made of a semiconductor material. For example, a semiconductor such as zinc selenide or gallium nitride can be used as the semiconductor material. The light emitting layer can be formed by means of metalorganic chemical vapor deposition, crystal growth method such as molecular beam epitaxy, or otherwise.

The frame 4, which is made of a ceramic material that is identical in composition with the substrate 2, is placed on the upper face of the substrate 2, so that it is fired with the substrate 2 in a unified manner. Alternatively, the frame 4 may be formed independently of the substrate 2. In this case, the frame 4 is configured to have a reflection surface at its inner wall. The frame 4, being a separate component, is bonded onto the substrate 2 via a transparent adhesive such as silicone resin.

In the case of forming the adhesive from a transparent material, light which has been transmitted directly to the adhesive from the light-emitting element 3, as well as light which has been emitted into the light-emitting device 1 from the wavelength converter 5 and transmitted to the adhesive, enters the adhesive. The light having entered the adhesive undergoes repetitive light reflection at the bonding surfaces of the substrate 1 and the frame 4, and part of the light is emitted into the light-emitting device 1. After that, the light portions act to excite the fluorescent substances within the wavelength converter 5, or are radiated out of the light-emitting device 1 after passing through the wavelength converter 5. If the adhesive is not transparent, the light which has been transmitted directly to the adhesive from the light-emitting element 3, as well as the light which has been emitted into the light-emitting device 1 from the wavelength converter 5 and transmitted to the adhesive, is likely to be absorbed into the adhesive, with the consequent increase of optical losses in the light-emitting device 1. In contrast, where the adhesive is transparent, part of light having entered the adhesive is emitted into the light-emitting device 1 and can thus be utilized as output light from the light-emitting device 1. In consequence, by bonding the frame 4 onto the substrate 2 via the transparent adhesive such as silicone resin, it is possible to lessen optical losses due to light absorption by the adhesive, and thereby enhance the light output capability of the light-emitting device.

The frame 4 is so disposed as to surround the light-emitting element 3 mounted on the substrate 2. The interior of the frame 4 is formed with a circular or rectangular through hole 4a for housing the light-emitting element 3. In the case where the through hole 4a of the frame 4 is circular in shape, the light emitted from the light-emitting element 3 can be reflected evenly in all directions and is thus caused to radiate outward with a very high degree of uniformity.

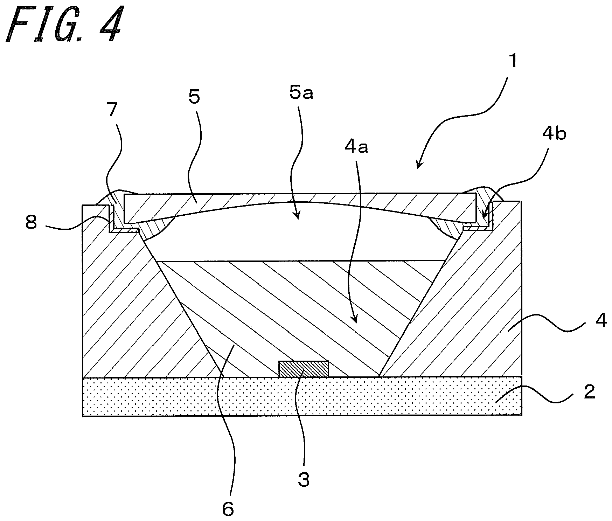

Moreover, when viewed in a cross-sectional view, the frame 4 is so shaped that its inner wall extends at a gradual widthwise incline from a lower portion to an upper portion thereof . Further, an upper end of the frame 4 is internally stepped to provide a shoulder 4b. An inclined inner wall of the frame 4 is formed with a metallic layer made for example of tungsten, molybdenum, copper, or silver, and a metallic plating layer 8 made of nickel, gold, or the like for covering the metallic layer. The metallic plating layer 8 has the capability of reflective dispersion of the light emitted from the light-emitting element 3. Alternatively, as shown in Fig. 4, in the case where the frame 4 is made of a ceramic material and the metallic plating layer 8 is not formed on the inner wall of the frame 4, it is advisable that the inner wall of the frame 4 is configured to have a ceramic material-made reflection surface in an exposed state. This enables reflective dispersion of the light emitted from the light-emitting element 3. As a result, the light which has been emitted from the light-emitting element 3 and thence reflectively dispersed by the frame 4 is allowed to enter the wavelength converter 5 while being restrained from converging to a specific location of the wavelength converter 5. That is, the light emitted from the light-emitting element 3 is less likely to converge to a specific location of the wavelength converter 5. This makes it possible to suppress effectively a decline in conversion efficiency in the specific location of the wavelength converter 5 or a decline in transmittance caused by a temperature rise in the specific location of the wavelength converter 5.

Moreover, the angle of inclination of the inner wall of the frame 4 is set to fall, for example, in a range of 55° or more and 70° or less with respect to the upper face of the substrate 2. Further, a surface roughness of the metallic plating layer 8 is set to fall, for example, in a range of 1 µm or more and 3 µm or less in terms of arithmetic mean height Ra.

The shoulder 4b of the frame 4 is provided for the sake of supporting the wavelength converter 5. The shoulder 4b is formed by cutting part of the top of the frame 4 inwardly, so that it is able to support the edge of the wavelength converter 5. Note that the metallic plating layer 8 extends over the surface of the shoulder 4b. By virtue of the interposition of the metallic plating layer 8 between the frame 4 and the wavelength converter 5, heat generated in the wavelength converter 5 can be dissipated from the wavelength converter 5 to the frame 4 through a resin 7 and the metallic plating layer 8. This makes it possible to protect the wavelength converter 5 from a temperature rise effectively.

In the light-emitting device as shown in Fig. 4, the metallic plating layer 8 is formed on the inner wall of the shoulder 4b, and the metallic plating layer 8 is contacted by the resin 7. On the other hand, the metallic plating layer 8 is not formed on a surface of the inner wall of the frame 4 other than the shoulder-bearing surface. In this way, heat transferred to the resin 7 from the wavelength converter 5 can be readily transmitted to the frame 4 through the metallic plating layer 8 formed on the shoulder 4b. Accordingly, in contrast to the case where the metallic plating layer 8 is formed on the entire surface of the inner wall of the frame 4, heat is less likely to be conducted through the region surrounded by the frame 4. This makes it possible to suppress a decline in the transmittance of a sealing resin 6 caused by heat, as well as to facilitate dissipation of heat from the frame 4 to the exterior thereof.

Moreover, the metallic plating layer 8 formed on the shoulder 4b is covered with the resin 7. By covering the metallic plating layer 8 with the resin 7, the heat transferred to the resin 7 from the wavelength converter 5 can be transmitted efficiently to the frame 4.

The sealing resin 6 is disposed in the region surrounded by the frame 4. The sealing resin 6 has the capabilities of sealing the light-emitting element 3 and permitting transmission of the light emitted from the light-emitting element 3 therethrough. Under the condition where the light-emitting element 3 is housed inside the frame 4, the sealing resin 6 is charged into the region surrounded by the frame 4 so that it is maintained at a level lower than the position of the shoulder 4b. Note that transparent insulating resin such for example as silicone resin, acrylic resin, or epoxy resin is used as the sealing resin 6.

The sealing resin 6 is disposed in the region surrounded by the frame 4 so as to cover the light-emitting element 3. At this time, a gap is created between the sealing resin 6 and the wavelength converter 5. In the presence of gas in the gap, there is a difference in refractive index between the sealing resin 6 and the gas. Due to the difference, a change in the direction of light travel or reflection of light may occur at the interface between the sealing resin 6 and the gas. Therefore, of the light traveling from the sealing resin 6 toward the wavelength converter 5, part of a first light portion, which is reflected from the wavelength converter 5 toward the sealing resin 6, is reflected at the interface between the gas and the sealing resin 6, and that part becomes a second light portion which travels toward the wavelength converter 5 once again. At this time, the traveling direction of the second light portion includes directions different from the direction in which the first light portion travels from the wavelength converter 5 toward the sealing resin 6. This helps lessen the occurrence of convergence of light to a specific location of the wavelength converter 5.

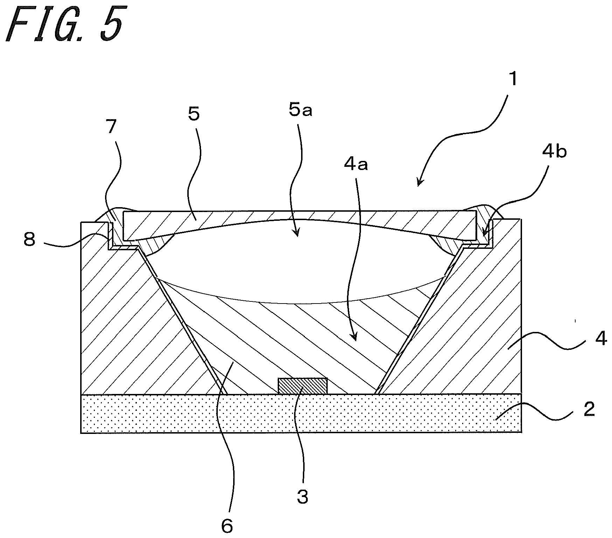

Moreover, as shown in Fig. 5, the upper face of the sealing resin 6 is curved downwardly from its edge situated at the inner wall of the frame 4 toward its center to provide a concave surface. The distance between the upper face of the edge of the sealing resin 6 and the lower face of the wavelength converter 5 located immediately above that upper face is set to be narrower than the distance between the upper face of the center of the sealing resin 6 and the lower face of the wavelength converter 5 located immediately above that center. By imparting a concavely curved profile to the upper face of the sealing resin 6, it is possible to facilitate reflection of light traveling from the wavelength converter 5 toward the sealing resin 6 at the upper face of the sealing resin 6, and thereby lessen the occurrence of convergence of light to a specific location of the wavelength converter 5 and also enhance the efficiency of light acquisition.

In the wavelength converter 5, upon the entrance of the light emitted from the light-emitting element 3, fluorescent substances contained therein are excited for emission of wavelength-converted light. The wavelength converter 5 is made of silicone resin, acrylic resin, epoxy resin, or the like that contains a blue phosphor for giving forth fluorescence in a range of 430 nm or more and 490 nm or less for example, a green phosphor for giving forth fluorescence in a range of 500 nm or more and 560 nm or less for example, a yellow phosphor for giving forth fluorescence in a range of 540 nm or more and 600 nm or less for example, and a red phosphor for giving forth fluorescence in a range of 590 nm or more and 700 nm or less for example. Note that the phosphors are dispersed evenly in the wavelength converter 5.

The wavelength converter 5 is supported on the frame 4 so as to be opposed at an interval from the light-emitting element 3. The wavelength converter 5 has a thickness becoming smaller from an edge toward a center of the wavelength converter 5. The wavelength converter 5 is disposed, with its center situated immediately above the light-emitting element 3.

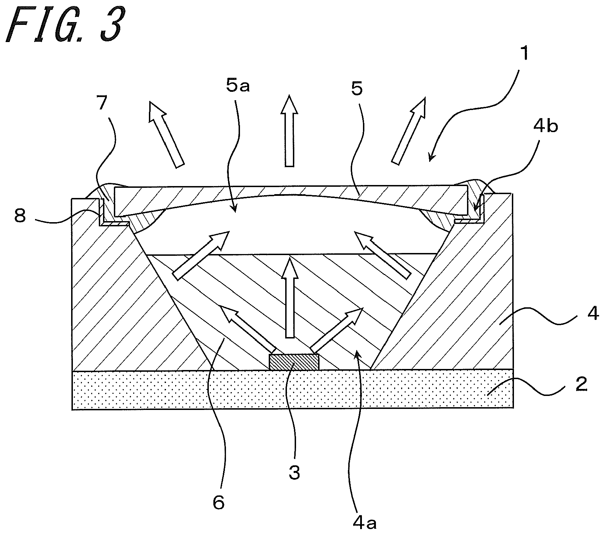

Fig. 3 is a sectional view of the light-emitting device, illustrating light which is being emitted from the light-emitting element. Arrows depicted in Fig. 3 indicate directions of travel of many light portions. The light-emitting element 3 is placed in a region overlapping the center of the lower face of the wavelength converter 5.

As shown in Fig. 3, the light emitted from the light-emitting element 3 tends to be reflected from the inner wall of the frame 4 so as to converge to the center of the wavelength converter 5. With this in view, the thickness of the center of the wavelength converter 5 subjected to convergence of the light emitted from the light-emitting element 3 is reduced for adjustment to the quantity of light which is excited by the light emitted from the light-emitting element 3.

That is, the light emitted from the light-emitting element 3 is, when reaching the wavelength converter 5, likely to converge to the center of the wavelength converter 5 rather than the edge of the wavelength converter 5. Therefore, if the wavelength converter 5 has a uniform thickness throughout its entirety, the center of the wavelength converter 5 will emit, following the completion of conversion, more light than does the edge of the wavelength converter 5. In this case, since many of the light portions excited within the wavelength converter 5 are emitted from the center of the wavelength converter 5, it follows that luminance varies significantly between the center and the edge in the wavelength converter 5 when viewed in a plan view. On the other hand, in the light-emitting device 1 according to the present invention, the wavelength converter 5 has the thickness becoming smaller from the edge toward the center of the wavelength converter 5. This makes it possible to reduce the quantity of light which is excited at the center of the wavelength converter 5 by the light emitted from the light-emitting element 3, and thereby suppress the variation of luminance between the center and the edge in the wavelength converter 5 when viewed in a plan view.

The wavelength converter 5 is formed with a concave 5a at its lower face opposed to the light-emitting element 3. The light emitted from the light-emitting element 3 tends to be reflected from the inner wall of the frame 4 so as to converge to the center of the wavelength converter 5. Therefore, by forming the concave 5a at the lower face of the wavelength converter 5, it is possible to obtain the effect of enveloping light traveling toward the wavelength converter 5 for the reduction of the quantity of light reflected from the lower face of the wavelength converter 5, and thereby achieve enhancement in external quantum efficiency. The concave 5a has the shape of a semi-sphere whose center coincides with the center of the wavelength converter 5 located above the light-emitting element 3. With the formation of the concave 5a in the wavelength converter 5, the lower face of the wavelength converter 5 can be inclined with respect to the upper face of the light-emitting element 3. In this case, the light coming from the light-emitting element 3 is less likely to be reflected from the lower face of the wavelength converter 5, wherefore the light coming from the light-emitting element 3 is allowed to enter the wavelength converter 5 with a high degree of efficiency.

Meanwhile, if the concave 5a is formed on the upper face of the wavelength converter 5 instead of the lower face thereof, in contrast to the case of forming the concave 5a on the lower face of wavelength converter 5, the light coming from the light-emitting element 3 is prone to being reflected from the lower face of the wavelength converter 5. This leads to a decrease in the effect of enhancing the wavelength conversion efficiency.

Moreover, the edge of the wavelength converter 5 is situated on the shoulder of the frame 4, and thus the wavelength converter 5 is surrounded, at its periphery, by the frame 4. Therefore, the light which has been emitted from the light-emitting element 3 and has entered the wavelength converter 5 may possibly reach the edge in the interior of the wavelength converter 5. In this case, by causing the light, now traveling from the edge of the wavelength converter 5 toward the frame 4, to reflect from the frame 4, the reflected light can be returned into the wavelength converter 5 once again. As a result, the light which has returned into the wavelength converter 5 can be excited by the fluorescent substances, with the consequent enhancement of the light output capability of the light-emitting device 1.

Moreover, the edge of the wavelength converter 5 has a uniform thickness. In this regard, the language "uniform thickness" is construed as encompassing thickness deviation of 0.5 µm or less. By configuring the edge of the wavelength converter 5 to have a uniform thickness, it is possible to effect adjustment so that light can be excited in a uniform light quantity throughout the perimeter of the wavelength converter 5, and thereby suppress unevenness in luminance along the perimeter of the wavelength converter 5.

In this construction, the thickness of the edge of the wavelength converter 5 is set to fall, for example, in a range of 0.7 mm or more and 3 mm or less. Moreover, the thickness of the concave 5a-bearing part of the wavelength converter 5 is set to fall, for example, in a range of 0.3 mm or more and 2.6 mm or less. Further, the difference in thickness between the edge of the wavelength converter 5 and the concave 5a-bearing part of the wavelength converter 5 is set to fall, for example, in a range of 0.4 mm or more and 2.7 mm or less. This thickness difference corresponds to the extent of the gradual change in thickness of the wavelength converter from the edge to the center thereof. Thus, the rate of thickness change in that part of the wavelength converter 5 situated on the shoulder 4b of the frame 4 is set to be smaller than the rate of thickness change in the concave 5a-bearing part of the wavelength converter 5.

When viewed in a plan view, the edge of the concave 5a of the wavelength converter 5 is positioned on the shoulder 4b of the frame 4. The wavelength converter 5 is fixed, at its edge, onto the shoulder 4b of the frame 4 via the resin 7. The resin 7 extends from the edge of the wavelength converter 5 to the position of the edge of the concave 5a of the wavelength converter 5. Note that transparent insulating resin such for example as silicone resin, acrylic resin, or epoxy resin is used as the resin 7.

In the range of the lower face of the wavelength converter 5, a coating of the resin 7 extends from the edge of the wavelength converter 5 to the concave 5a of the wavelength converter 5. This makes it possible to increase the area of the coating of the resin 7, and thereby connect the frame 4 with the wavelength converter 5 firmly. As a result, the strength of connection between the frame 4 and the wavelength converter 5 can be increased, wherefore the wavelength converter 5 can be protected against distortion. In addition, a change of the optical distance between the light-emitting element 3 and the wavelength converter 5 can be suppressed effectively.

According to the present invention, the thickness of the wavelength converter 5 situated above the light-emitting element 3 becomes smaller from the edge toward the center of the wavelength converter 5. This makes it possible to effect adjustment so that the amount of excitation of the fluorescent substances within the wavelength converter 5 by the light emitted from the light-emitting element 3 can be rendered uniform throughout the entire surface of the wavelength converter 5 when viewed in a plan view. As a result, there is provided the light-emitting device 1 capable of enhancing the uniformity of light acquired from the wavelength converter 5.

It should be understood that the present invention is not limited to the specific embodiment described heretofore, and that many modifications and variations of the present invention are possible within the scope as defined by the claims.

### <Method of manufacturing Light-emitting device>

Now, a description will be given below as to a manufacturing method for the light-emitting device as shown in Fig. 1 or Fig. 2.

To begin with, the substrate 2 and the frame 4 are prepared. For example, in the case of forming the substrate 2 and the frame 4 from aluminum oxide sintered compact, an organic binder, a plasticizer or a solvent, and so forth are admixed in raw material powder such as aluminum oxide, silicon oxide, magnesium oxide, calcium oxide, and the like to obtain a mixture.

Subsequently, the mixture is charged into mold forms for the substrate 2 and the frame 4. Following the completion of drying process, unsintered molded products of the substrate 2 and the frame 4 are taken out.

Moreover, powder of high-melting-point metal such as tungsten, molybdenum, or the like is prepared for use. An organic binder, a plasticizer or a solvent, and so forth are admixed in the powder to obtain a metal paste. The metal paste is printed in a predetermined pattern onto ceramic green sheets constituting the substrate 2 taken out previously, and a plurality of the ceramic green sheets are laminated on top of each other. Then, ceramic green sheets constituting the frame 4 are bonded onto the laminated ceramic green sheets constituting the substrate 2, and they are fired in a unified manner under pressure.

Next, the surface of the wiring conductor exposed internally or externally of the substrate 2 is coated with a plating layer for protection of the wiring conductor against oxidation. Then, the light-emitting element 3 is placed on the plating layer for electrical connection via solder.

Moreover, for example, silicone resin is charged into the region surrounded by the frame 4. The silicone resin is cured to thereby form the sealing resin 6.

Next, the wavelength converter 5 is prepared. The wavelength converter 5 can be formed by mixing fluorescent substances in resin in an uncured state, and shaping the mixture by means of a sheet molding technique such for example as the doctor blade method, the die coater method, the extrusion method, the spin coating method, or the dipping method. For example, the wavelength converter 5 can be obtained by charging the uncured material for the wavelength converter 5 into a mold form, and taking it out of the mold form following the completion of curing process.

Lastly, the thereby prepared wavelength converter 5 is bonded onto the shoulder 4b of the frame 4 via resin. In this way, the light-emitting device 1 can be manufactured.

## Claims

1. A light-emitting device (1), comprising:
a substrate (2);
a light-emitting element (3) mounted on the substrate (2);
a frame (4) disposed on the substrate (2) so as to surround the light-emitting element (3);
a wavelength converter (5) supported on the frame (4) so as to be opposed at an interval from the light-emitting element (3),
wherein the wavelength converter (5) has a thickness becoming smaller from an edge toward a center of the wavelength converter (5), and
a sealing resin (6) disposed in the region surrounded by the frame (4) so as to cover the light-emitting element (3),
**characterized in that**
a gap is provided between the sealing resin (6) and the wavelength converter (5), the upper face of the sealing resin (6) is curved downwardly from its edge situated at the inner wall of the frame (4) toward its center to provide a concave surface, and
the distance between the upper face of the edge of the sealing resin (6) and the lower face of the wavelength converter (5) located immediately above that upper face is set to be narrower than the distance between the upper face of the center of the sealing resin (6) and the lower face of the wavelength converter (5) located immediately above that center.

2. The light-emitting device (1) according to claim 1,
wherein the wavelength converter (5) is disposed, with the center of the wavelength converter (5) situated immediately above the light-emitting element (3).

3. The light-emitting device (1) according to claim 1 or 2,
wherein the wavelength converter (5) is formed with a concave (5a) at its lower face opposed to the light-emitting element (3).

4. The light-emitting device (1) according to claim 3,
wherein, when viewed in a cross-sectional view, a region surrounded by the frame (4) is so shaped that its width becomes larger from a lower portion to an upper portion thereof, and
an upper end of the frame (4) is internally stepped to provide a shoulder (4b), and an edge of the concave (5a) is positioned on the shoulder (4b) when viewed in a plan view,

5. The light-emitting device (1) according to claim 4,
wherein the shoulder (4b) of the frame (4) and the edge of the wavelength converter (5) are fixed to each other via a resin (7) which extends over the concave (5a) of the wavelength converter (5).

6. The light-emitting device (1) according to claim 1,
wherein the light-emitting element (3) is placed in a region overlapping a center of the lower face of the wavelength converter (5).

7. The light-emitting device (1) according to claim 5,
wherein the shoulder (4b) has a metallic plating layer (8) formed on its inner wall, and the metallic plating layer (8) and the resin (7) are kept in contact with each other,

8. The light-emitting device (1) according to claim 7,
wherein the metallic plating layer (8) is covered with the resin (7).

## Patentansprüche

1. Eine lichtemittierende Vorrichtung (1), aufweisend:
ein Substrat (2),
ein lichtemittierendes Element (3), das auf dem Substrat (2) montiert ist,
einen Rahmen (4), der auf dem Substrat (2) angeordnet ist, um das lichtemittierende Element (3) zu umgeben,
einen Wellenlängenwandler (5), der auf dem Rahmen (4) abgestützt ist, um dem lichtemittierenden Element (3) in einem Abstand gegenüberzuliegen,
wobei der Wellenlängenwandler (5) eine Dicke hat, die von einem Rand in Richtung zu einer Mitte des Wellenlängenwandlers (5) kleiner wird, und
ein Dichtungsharz (6), das in dem von dem Rahmen (4) umgebenen Bereich angeordnet ist, um das lichtemittierende Element (3) zu bedecken,
**dadurch gekennzeichnet, dass**
eine Lücke zwischen dem Dichtungsharz (6) und dem Wellenlängenwandler (5) vorgesehen ist,
die Oberseite des Dichtungsharzes (6) von seinem Rand, der sich an der Innenwand des Rahmens (4) befindet, in Richtung zu seiner Mitte nach unten gekrümmt ist, um eine konkave Fläche bereitzustellen, und
der Abstand zwischen der Oberseite des Randes des Dichtungsharzes (6) und der Unterseite des Wellenlängenwandlers (5), die direkt über dieser Oberseite angeordnet ist, eingestellt ist, um schmaler als der Abstand zwischen der Oberseite der Mitte des Dichtungsharzes (6) und der Unterseite des Wellenlängenwandlers (5) zu sein, die direkt über dieser Mitte angeordnet ist.

2. Die lichtemittierende Vorrichtung (1) gemäß Anspruch 1,
wobei der Wellenlängenwandler (5) derart angeordnet ist, dass sich die Mitte des Wellenlängenwandlers (5) direkt über dem lichtemittierenden Element (3) befindet.

3. Die lichtemittierende Vorrichtung (1) gemäß Anspruch 1 oder 2,
wobei der Wellenlängenwandler (5) mit einer Höhlung (5a) an seiner Unterseite, die dem lichtemittierenden Element (3) gegenüberliegt, ausgebildet ist.

4. Die lichtemittierende Vorrichtung (1) gemäß Anspruch 3,
wobei in einer Querschnittsansicht betrachtet ein von dem Rahmen (4) umgebener Bereich derart geformt ist, dass seine Breite von einem unteren Abschnitt zu einem oberen Abschnitt davon größer wird, und
ein oberes Ende des Rahmens (4) innen gestuft ist, um eine Schulter (4b) bereitzustellen, und ein Rand der Höhlung (5a) in einer Draufsicht betrachtet auf der Schulter (4b) positioniert ist.

5. Die lichtemittierende Vorrichtung (1) gemäß Anspruch 4,
wobei die Schulter (4b) des Rahmens (4) und der Rand des Wellenlängenwandlers (5) über ein Harz (7) aneinander befestigt sind, das sich über die Höhlung (5a) des Wellenlängenwandlers (5) erstreckt.

6. Die lichtemittierende Vorrichtung (1) gemäß Anspruch 1,
wobei das lichtemittierende Element (3) in einem Bereich angeordnet ist, der mit einer Mitte der Unterseite des Wellenlängenwandlers (5) überlappt ist.

7. Die lichtemittierende Vorrichtung (1) gemäß Anspruch 5,
wobei die Schulter (4b) eine metallische Plattierungsschicht (8) hat, die an ihrer Innenwand ausgebildet ist, und die metallische Plattierungsschicht (8) und das Harz (7) miteinander in Kontakt gehalten werden.

8. Die lichtemittierende Vorrichtung (1) gemäß Anspruch 7,
wobei die metallische Plattierungsschicht (8) mit dem Harz (7) bedeckt ist.

## Revendications

1. Un dispositif électroluminescent (1), comportant :
un substrat (2),
un élément électroluminescent (3) monté sur le substrat (2),
un cadre (4) disposé sur le substrat (2) de manière à entourer l'élément électroluminescent (3),
un convertisseur de longueur d'onde (5) supporté sur le cadre (4) de manière à être opposé à un écart de l'élément électroluminescent (3),
dans lequel le convertisseur de longueur d'onde (5) a une épaisseur diminuant d'un bord vers un centre du convertisseur de longueur d'onde (5),
et une résine de scellement (6) disposée dans la région entourée par le cadre (4) de manière à recouvrir l'élément électroluminescent (3),
**caractérisé en ce que**
un espace est prévu entre la résine de scellement (6) et le convertisseur de longueur d'onde (5),
la face supérieure de la résine de scellement (6) est courbée vers le bas à partir de son bord situé à la paroi intérieure du cadre (4) vers son centre pour fournir une surface concave, et
la distance entre la face supérieure du bord de la résine de scellement (6) et la face inférieure du convertisseur de longueur d'onde (5) située directement au-dessus de la face supérieure est adaptée de manière à être plus étroite que la distance entre la face supérieure du centre de la résine de scellement (6) et la face inférieure du convertisseur de longueur d'onde (5) disposé directement au-dessus de ce centre.

2. Le dispositif électroluminescent (1) selon la revendication 1,
dans lequel le convertisseur de longueur d'onde (5) est disposé avec le centre du convertisseur de longueur d'onde (5) situé directement au-dessus de l'élément électroluminescent (3).

3. Le dispositif électroluminescent (1) selon la revendication 1 ou 2,
dans lequel le convertisseur de longueur d'onde (5) est formé avec une concavité (5a) à sa face inférieure opposée à l'élément électroluminescent (3).

4. Le dispositif électroluminescent (1) selon la revendication 3,
dans lequel, lorsque vue dans une vue en coupe, une région entourée par le cadre (4) est formée de sorte que sa largeur devient plus grande à partir d'une partie inférieure vers une partie supérieure de celle-ci, et
une extrémité supérieure du cadre (4) est en gradins à l'intérieur de manière à fournir une épaule (4b), et un bord de la concavité (5a) est positionné sur l'épaule (4b) dans une vue de dessus.

5. Le dispositif électroluminescent (1) selon la revendication 4,
dans lequel l'épaule (4b) du cadre (4) et le bord du convertisseur de longueur d'onde (5) sont fixés l'un à l'autre moyennant une résine (7) qui s'étend sur la concavité (5a) du convertisseur de longueur d'onde (5).

6. Le dispositif électroluminescent (1) selon la revendication 1,
dans lequel l'élément électroluminescent (3) est placé dans une région chevauchant un centre de la face inférieure du convertisseur de longueur d'onde (5).

7. Le dispositif électroluminescent (1) selon la revendication 5,
dans lequel l'épaule (4b) a une couche de placage métallique (8) formée sur sa paroi intérieure, et la couche de placage métallique (8) et la résine (7) sont maintenues en contact l'une avec l'autre.

8. Le dispositif électroluminescent (1) selon la revendication 7,
dans lequel la couche de placage métallique (8) est recouverte de la résine (7).
